# EUROPEAN PATENT SPECIFICATION

(11) **EP 3 836 164 B1**
(45) Date of publication and mention of the grant of the patent: **27.05.2026**
(21) Application number: 18929158.6
(22) Date of filing: 01.11.2018
(51) Int. Cl.: G21D 1/02, G06F 30/00

(54) **APPARATUS FOR EXPRESSING AND UTILIZING INTELLIGENT GENERAL ARRANGEMENT DRAWING OF ATOMIC POWER PLANT**
VORRICHTUNG ZUR EXPRESSION UND NUTZUNG EINER INTELLIGENTEN GESAMTZEICHNUNG EINES ATOMKRAFTWERKS
APPAREIL POUR CRÉER ET UTILISER LE DESSIN D'AGENCEMENT GÉNÉRAL INTELLIGENT D'UNE CENTRALE ÉLECTRIQUE ATOMIQUE

(30) Priority: 10.08.2018 KR 20180093789
(43) Date of publication of application: 16.06.2021
(73) Proprietor: Korea Hydro & Nuclear Power Co., Ltd, 38120 Gyeongsangbuk-do (KR)
(72) Inventor: LIM, Byung Ki, Daejeon 34101 (KR); MOON, Byeong Suk, Daejeon 34101 (KR); PARK, You Jin, Daejeon 34101 (KR)
(74) Representative: Habermann, Hruschka & Schnabel
(86) International application number: PCT/KR2018/013180
(87) International publication number: WO 2020/032320

(56) References cited:
- JP-A- 2015 055 558
- JP-A- 2017 133 922
- JP-B2- 3 164 757
- KR-A- 20150 004 129
- KR-B1- 100 900 530
- KR-B1- 100 900 530
- KR-B1- 101 021 486
- KR-B1- 101 021 486
- KR-B1- 101 509 716

## Description

### Technical Field

The present disclosure relates to a general arrangement (GA) drawing of an atomic power plant and, more particularly, to an apparatus for expressing a general arrangement (GA) drawing of an atomic power plant as an intelligent general arrangement (GA) drawing and for using the intelligent general arrangement (GA) drawing.

### Background Art

A general arrangement (GA) drawing that is used in the processes of design, construction, and O&M of an atomic power plant may be defined as a drawing that shows the positions of structures, systems, and machines for every level and building of the atomic power plant, that is, a general arrangement drawing.

The configuration of a GA drawing is composed of the positions of machines, the names of machines, the list of machines, and corresponding coordinates in corresponding levels and corresponding rooms of corresponding buildings where there is power plant equipment such as HVAC, electrical, instrumental, and mechanical equipment.

In particular, the general arrangement (GA) drawing of an atomic power plant is one of the important drawings that are used for examination of design, search of equipment positions, pre-simulation before logging of an operator, study of machine positions for new workers due to a design change in the construction process, and an equipment change during operation of the atomic power plant.

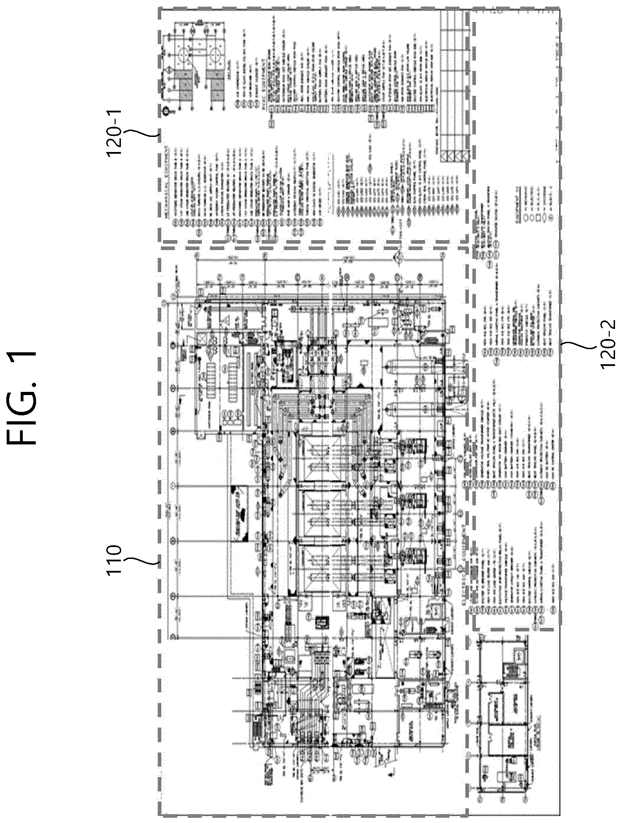

Since the list and positions of many power generation equipment in the levels and rooms of corresponding buildings are shown in the GA drawing, there is a limitation that it takes a user to search for corresponding machines in the GA drawing and legibility of the drawing is deteriorated. FIG. 1 is a machine arrangement drawing of a turbine building of an atomic power plant, which is one of GA drawings that are used in atomic power plants. As shown in FIG. 1, a GA drawing may be divided into a figure section 110 and equipment information sections 120-1 and 120-2.

All GA drawings for every corresponding area and position such as nuclear reactor buildings and containment buildings are managed by an enterprise resource planning system in the type of image documents for the drawing numbers, and if necessary, corresponding drawings are searched and used.

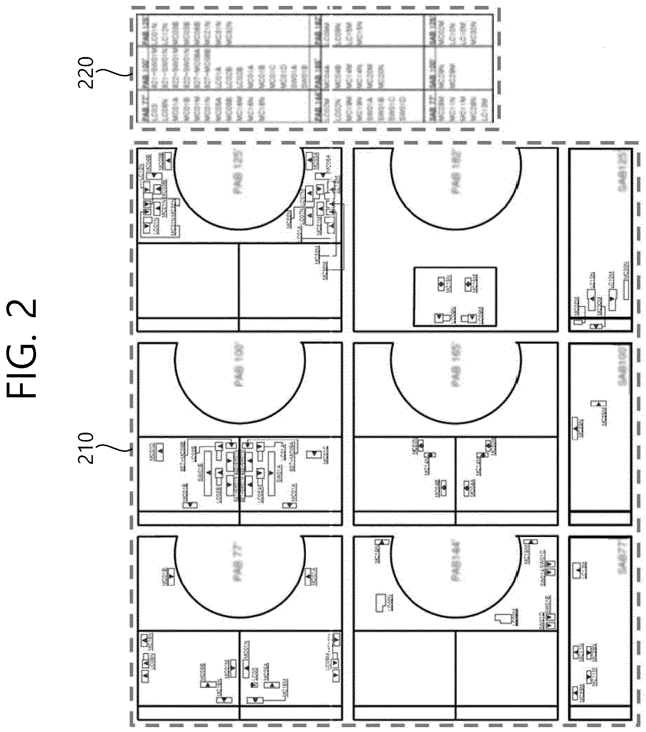

Further, machines that are frequently used during commissioning and operating of an atomic power plant such as the positions of a breaker and a valve that have the concepts of coordinates and a space are separately constructed in Hangeul or PDF files and used for the work of operators. FIG. 2 is a view showing the positions of breakers according to buildings and levels in a power plant. This may also be divided into a figure section 210 and an equipment information section 220. FIG. 2 shows an example of separately constructing and using the positions of breakers required for power supply of the equipment of an atomic power plant.

That is, general arrangement drawings are widely used for operation of an atomic power plant in the related art, but the drawings have a large amount of information in the drawing generated for each building and level and it is difficult to find out desired information from the large amount of information.
From KR 101021486 B1 a drawing information module is known which intellectualizes a system diagram of a nuclear or thermoelectric power plant and provides summary information of each facility to a user according to a selection by the user for a corresponding facility in the system diagram.

From KR 100900530 B1 a method is known for making a space map and a tool thereof, and an automation system using the same are provided to make efficient movement and search possible by enabling the automation system to perform space recognition. A tool for making a space map comprises a drawing part(110) and a standard space data unit(130). The drawing part produces a design drawing based on object information about an object which is inputted from user. The standard space data unit produces standard space data corresponding to the design drawing which the drawing part produces. KR20150004129A discloses a intelligent drawing control device and a respective method. The intelligent drawing control device according to KR20150004129A comprises the control command from the user and the control unit which controls in order to detect the generating unit producing one intelligent drawing including the input unit receiving the drafting file of the different multiple, and the multiple plant facility information and the plant facility information corresponded to the control command among multiple plant facility information and it outputs. The multiple plant facility information extracts the necessary information among the information respectively included with the file of the different multiple in the plant operation and is generated by collecting. According to the teaching of KR20150004129A , the plant facility can be easily grasped on and the administration and correction of drawing are facilitated.

### Disclosure

### Technical Problem

In order to solve the problems described above, an object of the present disclosure is to provide an apparatus for providing an intelligent GA drawing of an atomic power plant, the apparatus being able to change a GA drawing provided in relation to operation of an atomic power plant in the related art into an intelligent GA drawing so that individual machines are easily searched, and being able to maximize the usability of the GA drawing by adding additional functions such as search path setting and simulation for the workers of a power plant.

In order to solve the problems described above, another object of the present disclosure is to provide an apparatus for providing an intelligent GA drawing of an atomic power plant, the apparatus being able to improve workability of users by increasing efficiency and convenience for the user when the user uses a GA drawing by adding information and connecting relevant information without constructing a GA drawing into separate Hangeul or PDF files.

The present invention is defined by the subject matter of the appended claims.
FIG. 1 is a machine arrangement drawing of a turbine building of an atomic power plant.
FIG. 2 is a view showing the positions of breakers according to buildings and levels in a power plant.
FIG. 3 is a block diagram showing the configuration of an apparatus for providing an intelligent GA drawing of an atomic power plant according to an embodiment of the present disclosure.
FIG. 4 is an exemplary view of a GA drawing storage unit of FIG. 3.
FIG. 5 is an exemplary view of a process according to an object converter and a data processor of FIG. 3.
FIG. 6 is an exemplary view of a process according to a form processor of FIG. 3.
FIG. 7 is an exemplary view of a process according to a connection unit and a relevant-information storage unit of FIG. 3.
FIG. 8 is an exemplary view of a process according to an intelligent GA drawing utilization unit of FIG. 3.
FIG. 9 is an exemplary view of a process according to a customizer of FIG. 3.

### Mode for Disclosure

The present disclosure may be modified in various ways and implemented by various exemplary embodiments, so that specific exemplary embodiments are shown in the drawings and will be described in detail.

Terms used in the specification, "first", "second", etc., may be used to describe various components, but the components are not to be construed as being limited to the terms. The terms are used only to distinguish one component from another component. For example, the "first" component may be named the "second" component, and vice versa, without departing from the scope of the present disclosure. The term "and/or" includes a combination of a plurality of relevant items or any one of a plurality of relevant terms.

It is to be understood that when one element is referred to as being "connected to" or "coupled to" another element, it may be connected directly to or coupled directly to another element or be connected to or coupled to another element, having the other element intervening therebetween. On the other hand, it should be understood that when one element is referred to as being "connected directly to" or "coupled directly to" another element, it may be connected to or coupled to another element without the other element intervening therebetween.

Terms used in the present specification are used only to describe specific exemplary embodiments rather than limiting the present disclosure. Singular forms are intended to include plural forms unless the context clearly indicates otherwise. It will be further understood that the terms "comprises" or "have" used in this specification, specify the presence of stated features, steps, operations, components, parts, or a combination thereof, but do not preclude the presence or addition of one or more other features, numerals, steps, operations, components, parts, or a combination thereof.

Unless defined otherwise, it is to be understood that all the terms used in the specification including technical and scientific terms have the same meaning as those that are understood by those who skilled in the art. It will be further understood that terms defined in dictionaries that are commonly used should be interpreted as having meanings that are consistent with their meanings in the context of the relevant art and will not be interpreted in an idealized or overly formal sense unless expressly so defined herein.

Hereinafter, exemplary embodiments of the present disclosure will be described in more detail with reference to the accompanying drawings. In order to facilitate the general understanding of the present disclosure in describing the present disclosure, through the accompanying drawings, the same reference numerals will be used to describe the same components and an overlapped description of the same components will be omitted.

As described above, an apparatus for providing an intelligent GA drawing of an atomic power plant according to an embodiment of the present disclosure can change a GA drawing provided in relation to operation of an atomic power plant in the related art into an intelligent GA drawing so that individual machines are easily searched, and can maximize the usability of the GA drawing by adding additional functions such as search path setting and simulation for the workers of a power plant. Further, the apparatus can improve workability of users by increasing efficiency and convenience for the user when the user uses a GA drawing by adding information and connecting relevant information without constructing a GA drawing into separate Hangeul or PDF files.

In detail, according to the apparatus for providing an intelligent GA drawing of an atomic power plant of an embodiment of the present disclosure, it is possible to change a GA drawing based on documents that are used in an atomic power plant into an intelligent GA drawing, that is, to change corresponding equipments included in a GA drawing into objects and to provide IDs. Further, it is possible to improve workability by connecting relevant information to corresponding equipments and simulating movement paths by making a list of machines into data and implementing a function for enabling workers, who use the GA drawing when designing, constructing, and operating an atomic power plant, to easily trace the equipments of the plant such as constructing movement paths for operators and workers.

Further, according to the apparatus for providing an intelligent GA drawing of an atomic power plant of an embodiment of the present disclosure, it is possible to timely provide information to users who use the intelligent GA drawing such as operators and managers of the atomic power plant by automatically inputting relevant information (pictures, drawings, relevant information, etc.) about corresponding equipments or performing customizing to fit connectable individual demands.

Further, according to the apparatus for providing an intelligent GA drawing of an atomic power plant of an embodiment of the present disclosure, it is possible to timely provide accurate path information such as setting optimum paths, searching of comparative paths by constructing a movement path map, that is, a GA map for examining paths for examining equipments for operators, and setting movement spaces for workers from an objectified GA drawings required for constructing and operating an atomic power plant.

Further, according to the apparatus for providing an intelligent GA drawing of an atomic power plant of an embodiment of the present disclosure, it is possible to automatically connect pictures and/or 3D models of places corresponding to specific equipments and to enable users to easily input additional information even without using specific documents, pictures, and programs such as inputting breaker coordinates for corresponding equipments such as a breaker, if necessary, in order to compensate for the limitation of the 2D GA drawing for the positions of equipments in an atomic power plant.

Further, P&ID system drawings can be connected to corresponding machines, so it is possible to provide accurate and integral information about the positions and functions of corresponding equipments and to exclude a specific drawing search device.

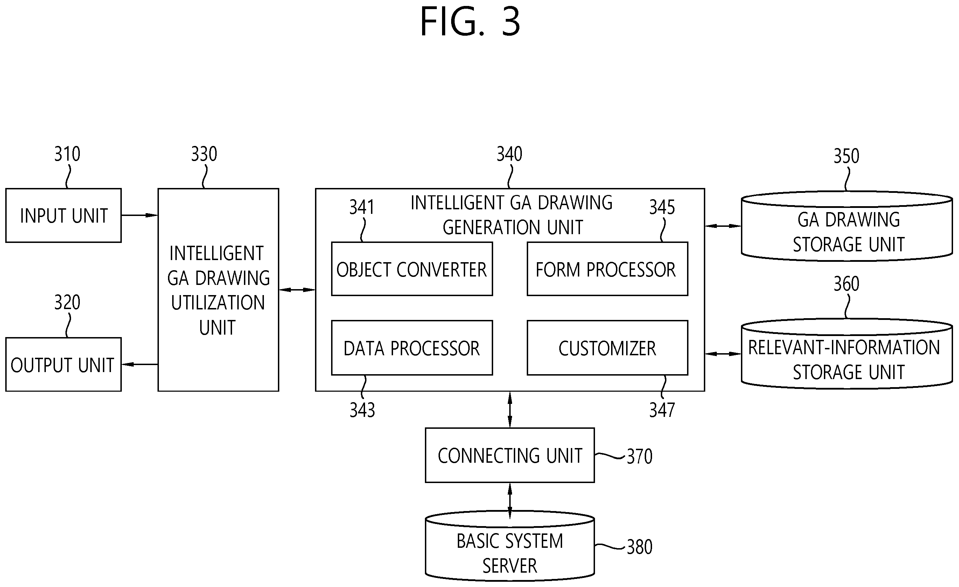

FIG. 3 is a block diagram showing the configuration of an apparatus for providing an intelligent GA drawing of an atomic power plant according to an embodiment of the present disclosure. Hereafter, an apparatus for providing an intelligent GA drawing of an atomic power plant according to an embodiment of the present disclosure is described in more detail with reference to FIG. 3.

As shown in FIG. 1, an apparatus for providing an intelligent GA (general arrangement) drawing of an atomic power plant according to an embodiment of the present disclosure may include an input unit 310, an output unit 320, an intelligent GA drawing utilization unit 330, an intelligent GA drawing generation unit 340, a GA drawing storage unit 350, a relevant-information storage unit 360, and a connection unit 370. The apparatus for providing an intelligent GA drawing of an atomic power plant can transmit/receive information to/from a basic system server 380 through the connection unit 370.

The GA drawing storage unit 350 may be configured to store one or more GA drawings in an image type for a specific level in a specific building of an atomic power plant. The intelligent GA drawing generation unit 340 can generate an intelligent GA drawing in which one or more equipments included in the Image-type GA drawing are objectified to be able to be discriminated and information about equipments are stored in a database, on the basis of the Image-type GA drawing stored in the GA drawing storage unit. The input unit 310 receives input about creation of the intelligent GA drawing or input about utilization from a user and the intelligent GA drawing utilization unit 330 can provide additional information about equipments included in a specific level of a specific building of the atomic power plant on the basis of the intelligent GA drawing in response to input about utilization of the user. The output unit 320 is configured to display the additional information such that the user can recognize the additional information.

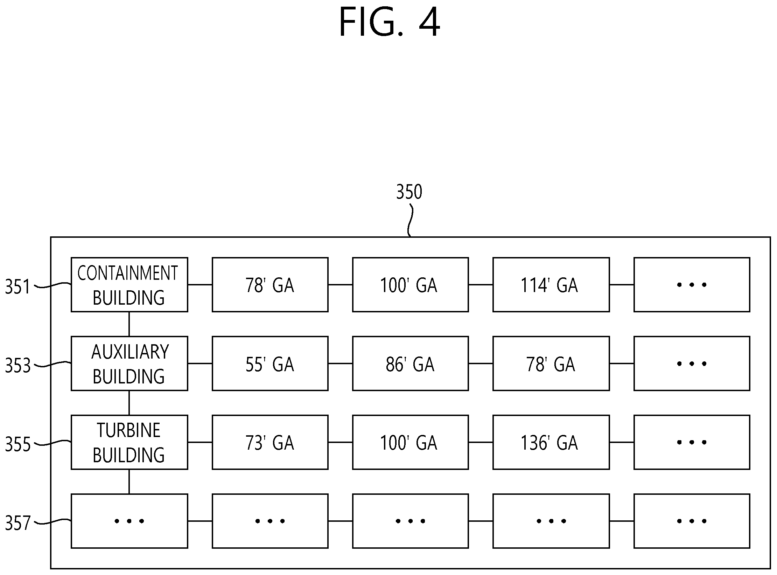

In more detail, FIG. 4 is an exemplary view of the GA drawing storage unit of FIG. 3. The GA drawing storage unit 350 may be configured to store one or more GA drawings in an image type for a specific level in a specific building of an atomic power plant. That is, the GA drawing storage unit 350 can function as a database DB integrally managing GA drawings, that is, the object of the present disclosure, and can store one or more GA drawings in an image type for each level of each of a containment building 351, an auxiliary building 353, a turbine building 355, and other buildings 357. The image-type GA drawings can be stored in the GA drawing storage unit 350 in the structure shown in FIG. 4.

Referring to FIG. 3 again, the intelligent GA drawing generation unit 340 can generate an intelligent GA drawing in which one or more equipments included in the Image-type GA drawing are objectified to be able to be discriminated and information about equipments are stored in a database, on the basis of the Image-type GA drawing. As shown in FIG. 3, the intelligent GA drawing generation unit 340 may include an object converter 341, a data processor 343, a form processor 345, and a customizer 347. The intelligent GA drawing generation unit 340 can convert it into data (object) generating equipment positions, etc., such as equipment and HVAC, which are components in a GA drawing constructed as a PDF file. That is, it is a device that can store contents corresponding to equipment, HVAC, etc. in a GA drawing into a database, if necessary, can generate and store additional data, and can be connected with a device for generating and converting data and an equipment machine form. The operation principle of a converting device that can implement a GA drawing constructed as a PDF file or a document file into data (object) in the related art is as follows. It is possible to perform objectification using a data converter or a data editor for converting corresponding equipments in a GA drawing into an intelligent type. That is, it may correspond to a data (object) converter using GA equipment information.

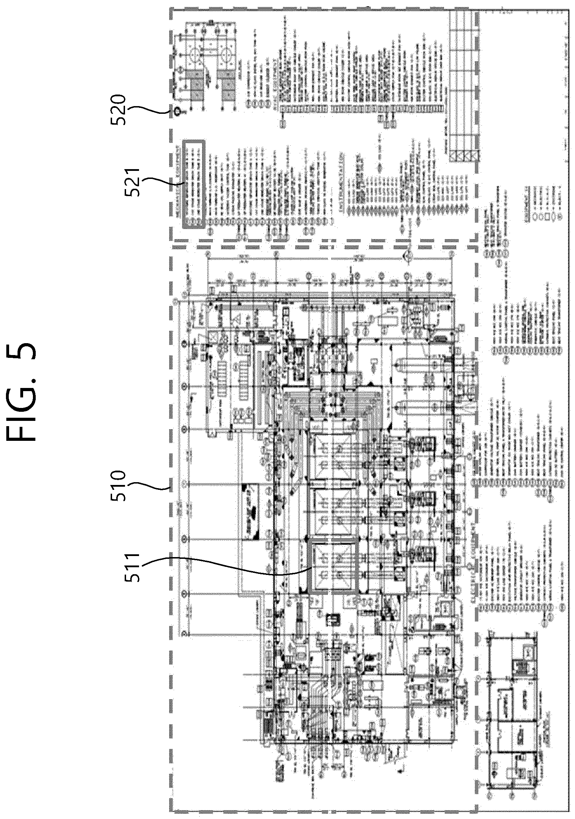

FIG. 5 is an exemplary view of a process according to an object converter 341 and a data processor 343 of FIG. 3. As shown in FIG. 5, the object converter 341 can recognize the figure 511 of a first equipment displayed in a figure section 4510 of an image-type GA drawing and can designate a first ID to the recognized first equipment, and can generate information of a text type by recognizing information 521 about the first equipment included in an equipment information section 520 of the image-type GA drawing. The data processor 343 can connect and store the first ID of the first equipment, information about the region where the figure of the first equipment is positioned in the image-type GA drawing, and the text-type information of the first equipment.

According to an aspect, the object converter 341 can recognize the figure of the first equipment in response to selection of the figure region of the first equipment by a user through the input unit 310. Further, according to an aspect, the object converter 341 can convert the information about the first equipment into text-type information by recognizing, as characters, the image of the portion about the information of the first equipment in the equipment information section of the image-type GA drawing.

As shown in FIG. 3, the intelligent GA drawing generation unit 340 may include the form processor 345 and the form processor 345 may be configured to generate additional information about an equipment included in a specific level of a specific building of the atomic power plant provided by the GA drawing utilization unit 330. In other words, the form processor 345 can extract a converted 2D GA drawing of the atomic power plant from a converter and can display movement paths in the atomic power plant, and may be configured to implement the function of the GA drawing utilization unit 330 that a user uses. Further, the form processor 345 can function as a plant map creation device using a drawing tool program and rendering tools for constructing movement paths for operators and workers of a GA drawing and a device that includes various utilities being able to edit a map and adding contents and implements a function of constructing functions that can be used in the intelligent GA drawing utilization unit 330 according to an embodiment of the present disclosure.

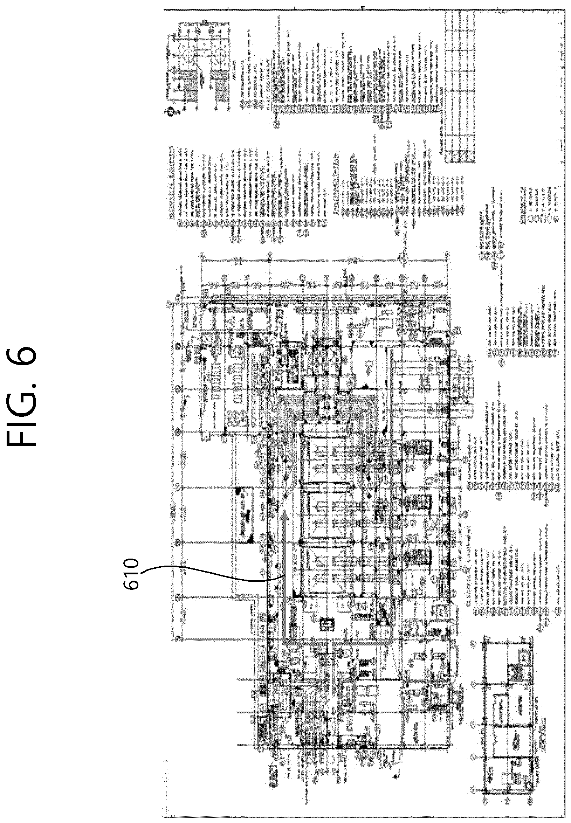

FIG. 6 is an exemplary view of a process according to the form processor of FIG. 3. Additional information about an equipment included in a specific level of a specific building of an atomic power plant, as shown in FIG. 6, may include information 610 about a movement path of an operator or a worker according to the arrangement of equipments recognized in the specific level.

According to an aspect, the form processor 345 can display a drawing tool button on the output unit 320 and can generate information about the movement path of an operator or a worker in response to a movement path input in accordance with operation of the drawing tool button by a user through the input unit 310. Further, the form processor 345 may be configured to generate information about a plurality of movement paths of operators or workers and the intelligent GA drawing generation unit 340 may be configured to display a movement path having the shortest distance of the plurality of movement paths of operators or workers on a display unit 320 by receiving an instruction to select the shortest path through the input unit 310.

As shown in FIG. 3, the apparatus for providing an intelligent GA drawing of an atomic power plant according to an embodiment of the present disclosure may include the relevant-information storage unit 360 and the connection unit 370.

The relevant-information storage unit 360 can store information about at least one of pictures, videos, and equipment manuals of one or more equipments included in an image-type GA drawing. The intelligent GA drawing utilization unit 330 may be configured to display relevant information about an equipment on the display unit 320 in response to selection of the equipment by a user through the input unit 310. The relevant-information storage unit 360 can store information required for a corresponding equipment such as a picture, a video, etc. of a site of a power plant equipment. Accordingly, the intelligent GA drawing according to an embodiment of the present disclosure can connect and manage pictures, videos, manuals of relevant machines, etc. of actual equipments and can immediately show corresponding contents after corresponding machines are clicked in order to compensate for the defects of GA drawings having a document form in the related art.

The connection unit 370 may be configured to receive a P&ID system drawing related to one or more equipments included in an image-type GA drawing from the basic system server 380 of the atomic power plant. The intelligent GA drawing utilization unit 330 may be configured to display a P&ID system drawing related to an equipment on the display unit 320 in response to selection of the equipment by a user through the input unit 310. The connection unit 370 can be connected with a data processor for inputting, changing, registering data of internal machines of power plant equipments using a data management tool or an enterprise resource planning system storing relevant information such as existing drawings. That is, it is possible to operate with the property of a basic system such as a P&ID and a corresponding 3D model in order to maximize the usability of an intelligent GA drawing.

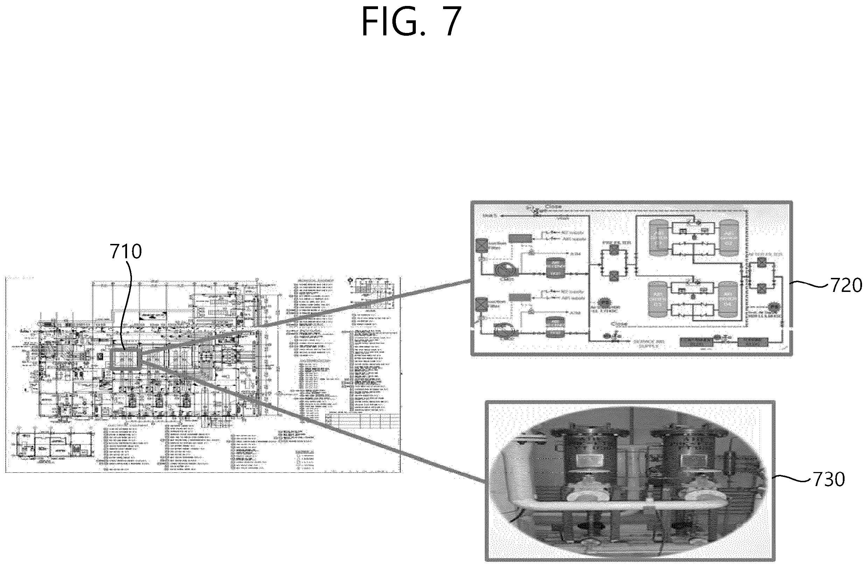

FIG. 7 is an exemplary view of a process according to a connection unit and a relevant-information storage unit of FIG. 3. As shown in FIG. 7, according to an aspect of the present disclosure, a P&ID system drawing related to an equipment 710 included a GA drawing may be displayed on the output unit 320 or a relevant image information 730 stored in the relevant-information storage unit 360 may be displayed on the output unit 320 by the connection unit 370.

Referring to FIG. 3 again, the intelligent GA drawing utilization unit 330 may be configured to provide additional information about an equipment included in a specific level of a specific building of the atomic power plant on the basis of the intelligent GA drawing in response to input about utilization of a user. That is, the intelligent GA drawing utilization unit 330 can set a shortest path, set an equipment operation monitoring path, and set the position of a worker in order to effectively use a 2D-map of the atomic power plant using the GA drawing. In more detail, it is a device for a method that displays a plant 2D map showing the entire power plant in 2D and that is used by a user.

According to an aspect, the intelligent GA drawing utilization unit 330 may be configured to change the display position of an intelligent GA drawing displayed on the output unit 320 in response to selection of a specific point by a user through the input unit 310. Further, according to an aspect, the intelligent GA drawing utilization unit 330 may be configured to display the intelligent GA drawing and a user-defined coordinate system on the output unit 320 in response to a display instruction by a user through the input unit 310 and to display a region of an intelligent GA drawing corresponding to user-defined coordinates on the output unit 320 in response to input of user-defined coordinates by the user through the input unit 310.

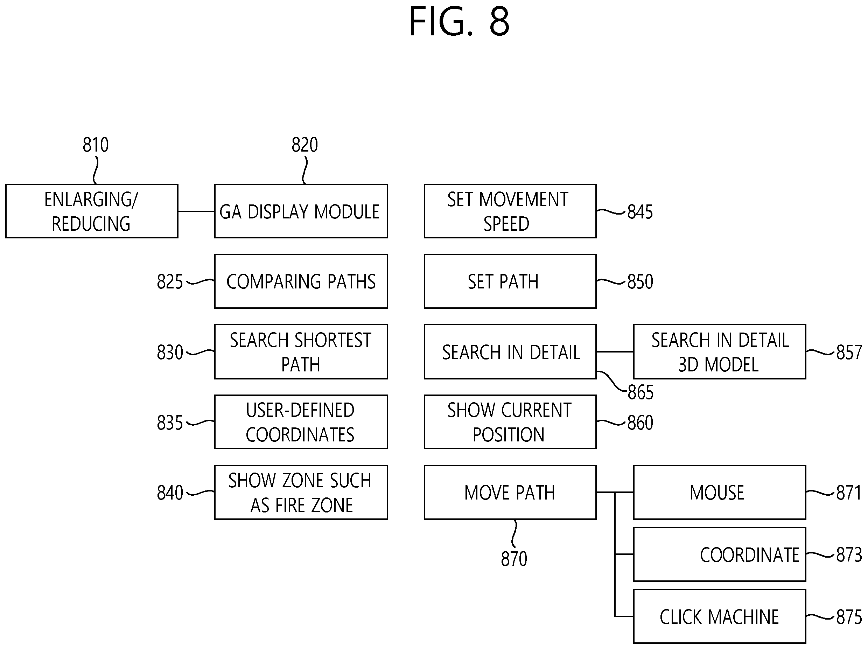

FIG. 8 is an exemplary view of a process according to an intelligent GA drawing utilization unit of FIG. 3. According to the plant 2D map, it is possible to search for a shortest path, set a work path, and compare paths by applying an interactive application method. Further, it may have various connection functions such as moving a map image according to mouse input, displaying a user-defined coordinate system, moving a map by coordinates, setting a fire zone, moving a map by clicking a corresponding machine, moving a path, setting a movement speed, providing work path selection information, finding out the current position of a worker, enlarging, reducing, moving, displaying, projecting an analysis result connection plant coordinate system/model, searching property, and visualizing a 3D map using a method of displaying a corresponding position.

That is, as shown in FIG. 8, it is possible to perform enlarging/reducing for information output on the output unit 320 (810), comparing paths through a GA display module 820 (825), searching for a shortest path (830), implementing user-defined coordinates (835), and showing a zone such as a fire zone (840). Further, it is possible to perform searching a 3D model in detail (857) and showing the current position (860) by setting a movement speed (845), setting a path (850), and searching in detail (865), and to perform moving a path (870) through a mouse 871, coordinates 873, or click of a machine 875.

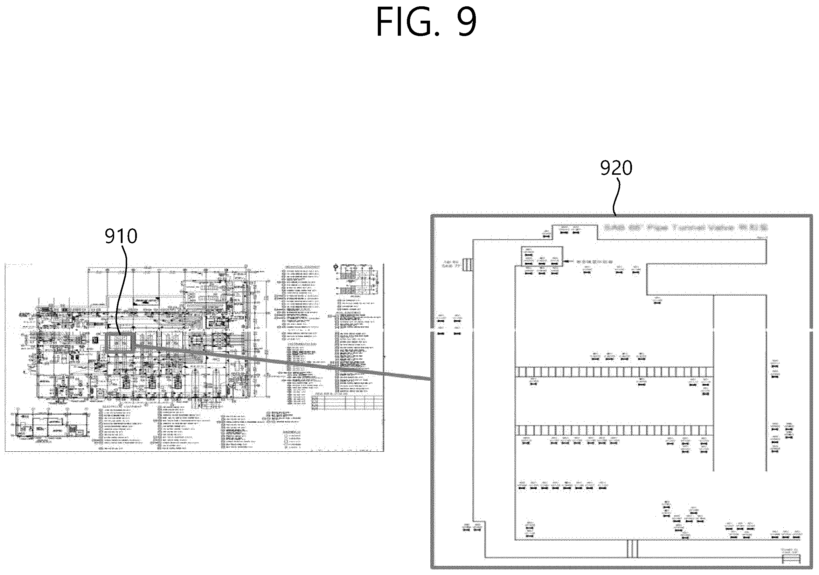

Referring to FIG. 3 again, the intelligent GA drawing generation unit 340 of the apparatus for providing an intelligent GA drawing of an atomic power plant according to an embodiment of the present disclosure may include the customizer 347. The customizer 347 may be configured as a personal customizer that can be customized in a user PC to be fit to personal work such as editing the position of breaker cabinet load for each corresponding position in GA and inputting a valve position drawing. In detail, it is possible to customize an intelligent GA drawing utilization system constructed by the utilization unit 330 according to an embodiment of the present disclosure to fit the object and the contents of personal work by storing it in a personal PC. In relation to this, FIG. 9 is an exemplary view of a process according to a customizer of FIG. 3. As shown in FIG. 9, for example, it may be possible to enable a user to add and change desired functions such as constructing a list of breakers or a list of valves in a specific area into a drawing file, a Word file, etc., and connecting the list to a machine position drawing. This makes it possible to secure convenience for a user by changing predetermined work to fit the characteristic of the user.

According to an aspect, the customizer 347 may be configured to connect an intelligent GA drawing to an additional information drawing for the work of a first user in response to input by a user through the input unit 310 such that the intelligent GA drawing provides information related to the work of the first user, in which the intelligent GA drawing utilization unit 330 can display the additional information drawing on the output unit 320 in response to an instruction to display an additional drawing by a user through the input unit 310. According to an aspect, the additional information drawing may include a list and position information 920 of breakers or valves for an equipment 910, for example, a breaker or a valve positioned at a specific level of a specific building of the atomic power plant indicated by an intelligent GA drawing.

The operation of the apparatus for providing an intelligent GA drawing of an atomic power plant according to the present disclosure may be controlled by computer-readable codes in a computer-readable recording medium. A computer-readable recording medium includes all kinds of recording media that keep data that can be decoded by a computer system. For example, there may be a ROM (Read Only Memory), a RAM (Random Access Memory), a magnetic tape, a magnetic disc, a flash memory, an optical data storage device, etc. Further, the computer-readable recording medium may be stored and executed as codes that are distributed in computer systems connected through a computer communication network and that can be read in a distribution type.

In detail, the features described above can be executed in a digital electronic circuit, or computer hardware, firmware, or combinations thereof. The features may be executed by a computer program product that is implemented in a storage device in a machine-readable storage device, for example, for execution by a programmable processor. Further, the features can be performed by a programmable processor that executes a program of commands for performing functions of the described embodiments by operating and creating output in input data. The described features can be executed in one or more computer programs that can be executed in a programmable system including at least one programmable processor, at least one input device, and at least one output device combined to receive data and commands from a data storage system and to transmit data and commands to the data storage system. The computer program includes a set of commands that can be directly or indirectly used in a computer to perform specific operations for predetermined results. The computer program can be written in any one of programming languages including combined or analyzed languages and can be used in any type included as another unit suitable to be used in module, element, subroutine, or other computer environments or a program that can be independently operated.

Processors suitable for executing a program of commands, for example, include both of microprocessors for a common use or a specific use, and a single processor or multiple processors of different kinds of computers. Further, storage devices suitable for implementing computer program commands and data for implementing the described features, for example, include all types of nonvolatile memories including semiconductor memory devices such as an EPROM, an EEPROM, and a flash memory device, magnetic devices such as internal hard disks and removable discs, magneto-optical devices, and CD-Rom and DVD-ROM discs. Processors and memories may be integrated in ASICs (application-specific integrated circuits) or may be added by ASICs.

## Claims

1. An apparatus for providing a General Arrangement, GA, drawing, referred to as intelligent GA drawing, of an atomic power plant, the apparatus comprising:
a GA drawing storage unit (350) configured to store at least one or more GA drawings of an image type for a specific level of a specific building of the atomic power plant;
an intelligent GA drawing generation unit (340) configured to generate an intelligent GA drawing from an Image-type GA drawing in which one or more equipments included in the Image-type GA drawing are objectified to be able to be discriminated and information about equipments are stored in a database, on the basis of the Image-type GA drawing;
an input unit (310) configured to receive input for generation or utilization of the intelligent GA drawing from a user;
an intelligent GA drawing utilization unit (330) configured to provide additional information about equipments included in a specific level of a specific building of the atomic power plant on the basis of the intelligent GA drawing in response to input about utilization of the user; and
an output unit (320) configured to display the additional information such that the user can recognize the additional information.
**characterized in that**
the intelligent GA drawing generation unit (340) further includes:
an object converter (341) configured to recognize a figure of a first equipment displayed in a figure section of the image-type GA drawing in response to selection of the figure region of the first equipment by a user through the input unit (310) and to designate a first ID to the recognized first equipment, and to generate information of a text type by recognizing information about the first equipment included in an equipment information section of the image-type GA drawing; and
a data processor (343) configured to connect and store the first ID of the first equipment, information about the region where the figure of the first equipment is positioned in the image-type GA drawing, and the text-type information of the first equipment.

2. The apparatus of claim 1, wherein the object converter (341) converts the information about the first equipment into text-type information by recognizing, as characters, the image of the portion about the information of the first equipment in the equipment information section of the image-type GA drawing.

3. The apparatus of claim 1, wherein the intelligent GA drawing generation unit (340) further includes a form processor (345) configured to generate additional information about an equipment included in a specific level of a specific building of the atomic power plant provided by the GA drawing utilization unit (330), and
the additional information about an equipment included in a specific level of a specific building of the atomic power plant includes information about a movement path of an operator or a worker according to the arrangement of equipments recognized in the specific level.

4. The apparatus of claim 3, wherein the form processor (345) displays a drawing tool button on the output unit (320) and generates information about the movement path of an operator or a worker in response to a movement path input in accordance with operation of the drawing tool button by a user through the input unit.

5. The apparatus of claim 4, wherein the form processor (345) generates information about a plurality of movement paths of operators or workers and the intelligent GA drawing generation unit (340) displays a movement path having the shortest distance of the plurality of movement paths of operators or workers on a display unit by receiving an instruction to select a shortest path through the input unit.

6. The apparatus of claim 1, wherein the intelligent GA drawing utilization unit (330) is configured to change the display position of an intelligent GA drawing displayed on the output unit (320) in response to selection of a specific point by a user through the input unit (310).

7. The apparatus of claim 1, wherein the intelligent GA drawing utilization unit (330) is configured to display the intelligent GA drawing and a user-defined coordinate system on the output unit (320) in response to a display instruction by a user through the input unit (310) and to display a region of an intelligent GA drawing corresponding to user-defined coordinates on the output unit (320) in response to input of user-defined coordinates by the user through the input unit (310).

8. The apparatus of claim 1, further comprising a relevant-information storage unit (360) configured to store information about at least one of pictures, videos, and equipment manuals of one or more equipments included in an image-type GA drawing,
wherein the intelligent GA drawing utilization unit (330) is configured to display relevant information about an equipment on the display unit in response to selection of the equipment by a user through the input unit 310).

9. The apparatus of claim 8, further comprising a connection unit (370) configured to receive a P&ID system drawing related to one or more equipments included in an image-type GA drawing from a basic system server (380) of the atomic power plant,
wherein the intelligent GA drawing utilization (330) unit is configured to display the P&ID system drawing related to an equipment on the display unit in response to selection of the equipment by a user through the input unit (310).

10. The apparatus of claim 1, wherein the intelligent GA drawing generation unit (340) further includes a customizer (347) configured to connect an intelligent GA drawing to an additional information drawing for the work of a first user in response to input by a user through the input unit (310) such that the intelligent GA drawing provides information related to the work of the first user,
wherein the intelligent GA drawing utilization unit (330) displays the additional information drawing on the output unit (320) in response to an instruction to display an additional drawing by a user through the input unit (310).

11. The apparatus of claim 10, wherein the additional information drawing includes a list and position information of breakers or valves positioned at a specific level of a specific building of the atomic power plant indicated by an intelligent GA drawing.

## Patentansprüche

1. Vorrichtung zur Bereitstellung einer Gesamtanordnungs-, GA, zeichnung, die als intelligente GA-Zeichnung bezeichnet wird, eines Kernkraftwerks, wobei die Vorrichtung aufweist:
eine GA-Zeichnungsspeichereinheit (350), die so konfiguriert ist, dass sie mindestens eine oder mehrere GA-Zeichnungen vom Bildtyp für eine bestimmte Ebene eines bestimmten Gebäudes des Kernkraftwerks speichert;
eine Erzeugungseinheit (340) für eine intelligente GA-Zeichnung, die so konfiguriert ist, dass sie eine intelligente GA-Zeichnung aus der bildatigen GA-Zeichnung erzeugt, in der eine oder mehrere in der bildartigen GA-Zeichnung enthaltene Anlagen objektiviert werden, um unterschieden werden zu können, und Informationen über die Anlagen in einer Datenbank auf der Grundlage der bildartigen GA-Zeichnung gespeichert werden;
eine Eingabeeinheit (310), die so konfiguriert ist, dass sie Eingaben zur Erzeugung oder Nutzung der intelligenten GA-Zeichnung von einem Benutzer empfängt;
eine Einheit (330) zur Nutzung einer intelligenten GA-Zeichnung, die so konfiguriert ist, dass sie auf der Grundlage der intelligenten GA-Zeichnung und als Reaktion auf Eingaben des Benutzers zur Nutzung zusätzliche Informationen über Anlagen bereitstellt, die in einer bestimmten Ebene eines bestimmten Gebäudes des Kernkraftwerks enthalten sind; und
eine Ausgabeeinheit (320), die so konfiguriert ist, dass sie die zusätzlichen Informationen so anzeigt, dass der Benutzer die zusätzlichen Informationen erkennen kann,
**dadurch gekennzeichnet, dass**
die Erzeugungseinheit (340) für eine intelligente GA-Zeichnung des Weiteren umfasst:
einen Objektkonverter (341), der so konfiguriert ist, dass er eine Abbildung einer ersten Anlage, die in einem Abbildungsabschnitt der bildartigen GA-Zeichnung angezeigt wird, als Reaktion auf die Auswahl des Abbildungsbereichs der ersten Anlage durch einen Benutzer über die Eingabeeinheit (310) erkennt und der erkannten ersten Anlage eine erste ID zuweist sowie Informationen vom Texttyp generiert, indem er Informationen über die erste Anlage erkennt, die in einem Anlageninformationsabschnitt der bildartigen GA-Zeichnung enthalten sind; und
einen Datenprozessor (343), der so konfiguriert ist, dass er die erste ID der ersten Anlage, Informationen über den Bereich, in dem die Abbildung der ersten Anlage in der bildartigen GA-Zeichnung positioniert ist, und die textartigen Informationen der ersten Anlage miteinander verknüpft und speichert.

2. Vorrichtung nach Anspruch 1, bei der der Objektkonverter (341) die Informationen über die erste Anlage in textartige Informationen umwandelt, indem er das Bild des Abschnitts über die Informationen der ersten Anlage im Anlageninformationsabschnitt der bildartigen GA-Zeichnung als Zeichen erkennt.

3. Vorrichtung nach Anspruch 1, bei der die Erzeugungseinheit (340) für eine intelligente GA-Zeichnung des Weiteren einen Formularprozessor (345) umfasst, der so konfiguriert ist, dass er zusätzliche Informationen über eine Anlage erzeugt, die in einer bestimmten Ebene eines bestimmten Gebäudes des Kernkraftwerks enthalten ist, die von der Einheit (330) zur Nutzung intelligenter GA-Zeichnungen bereitgestellt wird, und
die zusätzlichen Informationen über eine Anlage, die in einer bestimmten Ebene eines bestimmten Gebäudes des Kernkraftwerks enthalten ist, Informationen über einen Bewegungsweg eines Bedieners oder eines Arbeiters gemäß der Anordnung der in der bestimmten Ebene erkannten Anlagen umfassen.

4. Vorrichtung nach Anspruch 3, bei der der Formularprozessor (345) eine Zeichnungswerkzeug-Schaltfläche auf der Ausgabeeinheit (320) anzeigt und Informationen über den Bewegungsweg eines Bedieners oder Arbeiters als Reaktion auf eine Bewegungsweg-Eingabe gemäß einer Betätigung der Zeichnungswerkzeug-Schaltfläche durch einen Benutzer über die Eingabeeinheit erzeugt.

5. Vorrichtung nach Anspruch 4, bei der der Formularprozessor (345) Informationen über eine Vielzahl von Bewegungswegen von Bedienern oder Arbeitern erzeugt und die Erzeugungseinheit (340) für eine intelligente GA-Zeichnung einen Bewegungsweg mit der kürzesten Entfernung aus der Vielzahl von Bewegungswegen von Bedienern oder Arbeitern auf einer Anzeigeeinheit anzeigt, indem sie über die Eingabeeinheit eine Anweisung zur Auswahl eines kürzesten Weges empfängt.

6. Vorrichtung nach Anspruch 1, bei der die Einheit (330) zur Nutzung einer intelligenten GA-Zeichnung so konfiguriert ist, dass sie die Anzeigeposition einer auf der Ausgabeeinheit (320) angezeigten intelligenten GA-Zeichnung als Reaktion auf die Auswahl eines bestimmten Punktes durch einen Benutzer über die Eingabeeinheit (310) ändert.

7. Vorrichtung nach Anspruch 1, bei der die Einheit (330) zur Nutzung einer intelligenten GA-Zeichnung so konfiguriert ist, dass sie die intelligente GA-Zeichnung und ein benutzerdefiniertes Koordinatensystem auf der Ausgabeeinheit (320) als Reaktion auf einen Anzeigeauftrag eines Benutzers über die Eingabeeinheit (310) anzeigt und einen Bereich einer intelligenten GA-Zeichnung, der den benutzerdefinierten Koordinaten entspricht, auf der Ausgabeeinheit (320) als Reaktion auf die Eingabe benutzerdefinierter Koordinaten durch den Benutzer über die Eingabeeinheit (310) anzeigt.

8. Vorrichtung nach Anspruch 1, des Weiteren aufweisend eine Speichereinheit (360) für relevante Informationen, die so konfiguriert ist, dass sie Informationen über mindestens eines von Bildern, Videos und Gerätehandbüchern eines oder mehrerer Anlagen speichert, die in einer bildartigen GA-Zeichnung enthalten sind,
wobei die Einheit (330) zur Nutzung einer intelligenten GA-Zeichnung so konfiguriert ist, dass sie relevante Informationen über eine in der GA-Zeichnung enthaltene Anlage auf der Anzeigeeinheit anzeigt, als Reaktion auf die Auswahl der Anlage durch einen Benutzer über die Eingabeeinheit (310).

9. Vorrichtung nach Anspruch 8, des Weitern aufweisend eine Verbindungseinheit (370), die so konfiguriert ist, dass sie eine P&ID-Systemzeichnung, die sich auf eine oder mehrere in einer bildartigen GA-Zeichnung enthaltene Anlagen bezieht, von einem Basissystemserver (380) des Kernkraftwerks empfängt,
wobei die Einheit (330) zur Nutzung einer intelligenten GA-Zeichnung so konfiguriert ist, dass sie die P&ID-Systemzeichnung, die sich auf eine Anlage bezieht, auf der Anzeigeeinheit anzeigt, als Reaktion auf die Auswahl der Anlage durch einen Benutzer über die Eingabeeinheit (310).

10. Vorrichtung nach Anspruch 1, bei der die Erzeugungseinheit (340) für eine intelligente GA-Zeichnung ferner einen Konfigurator (347) umfasst, der so konfiguriert ist, dass er eine intelligente GA-Zeichnung als Reaktion auf eine Eingabe durch einen Benutzer über die Eingabeeinheit (310) mit einer Zusatzinformationszeichnung für die Arbeit eines ersten Benutzers verknüpft, so dass die intelligente GA-Zeichnung Informationen bereitstellt, die sich auf die Arbeit des ersten Benutzers beziehen,
wobei die Einheit (330) zur Nutzung intelligenter GA-Zeichnungen die Zusatzinformationszeichnung auf der Ausgabeeinheit (320) als Reaktion auf eine Anweisung zur Anzeige einer Zusatzzeichnung durch einen Benutzer über die Eingabeeinheit (310) anzeigt.

11. Vorrichtung nach Anspruch 10, bei der die Zusatzinformationszeichnung eine Liste und Positionsinformationen von Schaltern oder Ventilen enthält, die sich auf einer bestimmten Ebene eines bestimmten Gebäudes des durch eine intelligente GA-Zeichnung dargestellten Kernkraftwerks befinden.

## Revendications

1. Appareil destiné à fournir un dessin d'ensemble génerale, GA, appelé GA dessin intelligent, d'une centrale nucléaire, l'appareil comprenant:
une unité de stockage du GA dessin (350) configurée pour stocker au moins un ou plusieurs GA dessins de type image pour un niveau donné d'un bâtiment donné de la centrale nucléaire;
une unité de génération (340) d'un GA dessin intelligent, configurée pour générer un GA dessin intelligent à partir du GA dessin de type image, dans lequel un ou plusieurs équipements contenus dans le GA dessin de type image sont objectivés afin de pouvoir être distingués, et des informations sur les équipements sont stockées dans une base de données sur la base du GA dessin de type image;
une unité de saisie (310) configurée pour recevoir d'un utilisateur des entrées destinées à la génération ou à l'utilisation du GA dessin intelligent;
une unité (330) d'utilisation d'un GA dessin intelligent, configurée pour fournir, sur la base du GA dessin intelligent et en réponse aux entrées de l'utilisateur destinées à l'utilisation, des informations supplémentaires sur les équipements contenues dans un niveau donné d'un bâtiment donné de la centrale nucléaire; et
une unité de sortie (320) configurée pour afficher les informations supplémentaires de manière à ce que l'utilisateur puisse les percevoir,
**caractérisé en ce que**
l'unité de génération (340) d'un GA dessin intelligent comprend en outre:
un convertisseur d'objets (341) configuré pour reconnaître une image d'une première équipement affichée dans une section d'image du GA dessin de type image en réponse à la sélection de la zone d'image de la première équipement par un utilisateur via l'unité de saisie (310) et attribue un premier identifiant à la première équipement détectée, ainsi que génère des informations de type texte en détectant des informations sur la première équipement contenues dans une section d'informations sur les équipements du GA dessin de type image; et
un processeur de données (343) configuré pour associer et stocker le premier identifiant de la première équipement, des informations sur la zone dans laquelle l'image de la première équipement est positionnée dans le GA dessin de type image, et les informations de type texte de la première équipement.

2. Appareil selon la revendication 1, dans lequel le convertisseur d'objets (341) convertit les informations concernant la première équipement en informations de type texte en reconnaissant l'image de la section relative aux informations de la première équipement dans la section d'informations sur les équipements du GA dessin de type image comme des caractères.

3. Appareil selon la revendication 1, dans lequel l'unité de génération (340) d'un GA dessin intelligent comprend en outre un processeur de formulaires (345) configuré pour générer des informations supplémentaires concernant une annexe contenue dans un niveau donné d'un bâtiment donné de la centrale nucléaire, qui sont fournies par l'unité (330) d'utilisation d'un GA dessin intelligent, et
les informations supplémentaires concernant une èquipment située à un niveau donné d'un bâtiment donné de la centrale nucléaire comprenant des informations sur le parcours d'un opérateur ou d'un travailleur en fonction de la disposition des équipements détectées à cet niveau.

4. Appareil selon la revendication 3, dans lequel le processeur de formulaires (345) affiche un bouton d'outil de dessin sur l'unité de sortie (320) et génère des informations sur le trajet d'un opérateur ou d'un travailleur en réponse à une saisie de trajet correspondant à l'actionnement du bouton d'outil de dessin par un utilisateur via l'unité de saisie.

5. Appareail selon la revendication 4, dans lequel le processeur de formulaires (345) génère des informations concernant une pluralité de trajectoires d'opérateurs ou de travailleurs, et l'unité de génération (340) d'un GA dessin intelligent affiche sur une unité d'affichage la trajectoire présentant la distance la plus courte parmi la pluralité de trajectoires d'opérateurs ou de travailleurs, en recevant via l'unité de saisie une instruction de sélection d'un chemin le plus court.

6. Appareil selon la revendication 1, dans lequel l'unité (330) d'utilisation d'un GA dessin intelligent est configurée pour modifier la position d'affichage d'un GA dessin intelligent affiché sur l'unité de sortie (320) en réponse à la sélection d'un point spécifique par un utilisateur via l'unité de saisie (310).

7. Appareil selon la revendication 1, dans lequel l'unité (330) d'utilisation d'un GA dessin intelligent est configurée de manière à afficher le GA dessin intelligent et un système de coordonnées défini par l'utilisateur sur l'unité de sortie (320) en réponse à une commande d'affichage d'un utilisateur via l'unité de saisie (310) et affiche une zone d'un GA dessin intelligent correspondant aux coordonnées définies par l'utilisateur sur l'unité de sortie (320) en réponse à la saisie de coordonnées définies par l'utilisateur via l'unité de saisie (310).

8. Appareil selon la revendication 1, comprenant en outre une unité de stockage (360) d'informations pertinentes, configurée pour stocker des informations concernant au moins l'un parmi des images, des vidéos et des manuels d'utilisation d'un ou plusieurs équipements contenus dans un GA dessin de type image,
l'unité (330) d'utilisation d'un GA dessin intelligent étant configurée pour afficher sur l'unité d'affichage des informations pertinentes concernant une éuipement contenue dans le GA dessin, en réponse à la sélection de l'équipement par un utilisateur via l'unité de saisie (310).

9. Dispositif selon la revendication 8, comprenant en outre une unité de connexion (370) configurée pour recevoir, depuis un serveur de système de base (380) de la centrale nucléaire, un schéma P&ID de système se rapportant à une ou plusieurs équipment contenues dans un GA dessin de type image,
l'unité (330) d'utilisation d'un GA dessin intelligent étant configurée pour afficher le schéma P&ID se rapportant à une équipement sur l'unité d'affichage, en réponse à la sélection de l'équipement par un utilisateur via l'unité de saisie (310).

10. Appareil selon la revendication 1, dans lequel unité de génération (340) d'un GA dessin intelligent comprend en outre un configurateur (347) configuré pour associer un GA dessin intelligent à un schéma d'informations supplémentaires concernant le travail d'un premier utilisateur, en réponse à une entrée effectuée par un utilisateur via l'unité de saisie (310) associe un dessin d'informations supplémentaires au travail d'un premier utilisateur, de sorte que le GA dessin intelligent fournit des informations se rapportant au travail du premier utilisateur,
l'unité (330) d'utilisation d'un GA dessin intelligent affichant le plan d'informations supplémentaires sur l'unité de sortie (320) en réponse à une instruction d'affichage d'un plan supplémentaire donnée par un utilisateur via l'unité de saisie (310).

11. Apparail selon la revendication 10, dans lequel le dessin d'informations supplémentaires contient une liste et des informations de position de commutateurs ou de vannes situés à un niveau donné d'un bâtiment donné de la centrale nucléaire représentée par un GA dessin intelligent.
